# EUROPÄISCHE PATENTSCHRIFT

(11) **EP 1 709 359 B1**
(45) Veröffentlichungstag und Bekanntmachung des Hinweises auf die Patenterteilung: **27.07.2011**
(21) Anmeldenummer: 05726280.0
(22) Anmeldetag: 31.01.2005
(51) Int. Cl.: F21S 4/00, F21Y 101/02

(54) **VERFORMBARES BELEUCHTUNGSMODUL**
DEFORMABLE ILLUMINATION MODULE
MODULE D'ECLAIRAGE DEFORMABLE

(30) Priorität: 30.01.2004 DE 102004004777
(43) Veröffentlichungstag der Anmeldung: 11.10.2006
(73) Patentinhaber: OSRAM Opto Semiconductors GmbH, 93055 Regensburg (DE)
(72) Erfinder: SCHINZEL, Stephan, 93053 Regensburg (DE); STOYAN, Harald, 93049 Regensburg (DE)
(74) Vertreter: Epping - Hermann - Fischer
(86) Internationale Anmeldenummer: PCT/DE2005/000143
(87) Internationale Veröffentlichungsnummer: WO 2005/073618

(56) Entgegenhaltungen:
- EP-A2- 1 233 232
- WO-A-03/040612
- DE-A1- 10 052 380
- US-A- 4 654 766
- US-A- 6 017 241
- US-A- 6 027 952
- US-A1- 2003 063 463
- US-B1- 6 371 629

## Beschreibung

Die Erfindung betrifft ein verformbares Beleuchtungsmodul mit einer Mehrzahl von Leiterplatten, auf denen jeweils mindestens ein optischer Emitter angeordnet ist und die über elektrische Stromversorgungsdrähte zu einer Kette verschaltet sind. Sie bezieht sich insbesondere auf Beleuchtungsmodule zur Hinterleuchtung von lichtdurchlässigen Materialen wie z.B. Acryl in Leuchtbuchstaben.

Bekannte derartige Beleuchtungsmodule, wie beispielsweise das Tetra⁰ LED System von GELCore oder der LEDschlauch von Hansen-neon lassen keine Veränderungen der Abstände von Leuchtdiodenbauelement zu Leuchtdiodenbauelement zu und sind daher bezüglich einer Leuchtdichte nicht skalierbar und je nach Abstrahlcharakter hinsichtlich einer möglichst homogenen Leuchtdichte nur für einen sehr eingeschränkten Größenbereich von Leuchtbuchstaben einsetzbar. Darüber hinaus ist die maximale Länge dieser Beleuchtungsmodule sehr begrenzt.

Aus der Druckschrift US 2003/0063463 A1 ist eine Lichterkette mit Beleuchtungseinheiten bekannt, die jeweils eine PCB-Leiterplatte mit LEDs aufweisen. Die Leiterplatten sind mit Eingangsdrähten und mit Ausgangsdrähten verbunden, die an ihren Enden jeweils Stecker zur Verbindung der Beleuchtungseinheiten in der Lichterkette aufweisen.

Der vorliegenden Erfindung liegt die Aufgabe zu Grunde, ein vereinfacht herstellbares Beleuchtungsmodul der eingangs genannten Art bereitzustellen, bei dem die Leuchtdichte auf einfache Weise variiert werden kann und mit dem längere Ketten als bislang möglich sind.

Diese Aufgabe wird durch ein Beleuchtungsmodul mit den Merkmalen des Anspruches 1 gelöst. Vorteilhafte Weiterbildungen des Beleuchtungsmoduls sind in den Unteransprüchen angegeben.

Bei einem Beleuchtungsmodul gemäß der Erfindung ist eine Mehrzahl von Leiterplatten vorgesehen, auf denen jeweils mindestens ein optischer Emitter, insbesondere ein Leuchtdiodenbauelement, angeordnet ist und die über zwei massive elektrische Stromversorgungsdrähte zu einer Kette verschaltet sind. Die elektrischen Stromversorgungsdrähte laufen ohne Unterbrechung über alle Leiterplatten der Kette. Mittels dieser Stromversorgungsdrähte sind die Leiterplatten der Kette parallel zueinander verschaltet.

Unter den Begriff "ohne Unterbrechung" fallen alle Ausführungen, bei denen die Stromversorgungsdrähte an der Leiterplatte zwar durchtrennt sind, aber ohne wesentlicher Querschnittsverringerung auf der Leiterplatte elektrisch durchverbunden sind.

Die Leiterplatten sind gedruckte Leiterplatten (PCBs) oder Leiterplatten, die mittels MID-Technologie herstellbar sind, was beispielsweise Heißprägen umfasst.

Auf jeder Leiterplatte können neben dem mindestens einen optischen Emitter zusätzlich mindestens eine weitere elektronische Komponente angeordnet sein, die mit dem optischen Emitter elektrisch verschaltet ist.

Bei einer bevorzugten Ausführungsform sind die elektrischen Stromversorgungsdrähte zur Versteifung der Verbindung zwischen jeweils zwei Leiterplatten zwischen diesen zu einem Bündel verbunden, beispielsweise gecrimpt.

Bei einer besonderen Ausführungsform sind die Leiterplatten in eine Mehrzahl von Leiterplattenpaaren gruppiert und sind die optischen Emitter eines jeden Leiterplattenpaares mittels eines Verbindungsdrahtes zwischen den beiden Leiterplatten verschaltet.

Besonders bevorzugt sind die optischen Emitter Leuchtdiodenbauelemente.

Zwischen jeweils zwei Leiterplatten verlaufen die Stromversorgungsdrähte vorzugsweise mäanderartig. Dies ermöglicht einerseits eine Variation des Abstandes zwischen zwei Leiterplatten und andererseits kann der Biegeradius der Kette auf einfache Weise verändert werden.

Besonders bevorzugt verjüngen sich die Leiterplatten in Richtung ihrer einander zugewandten Enden und laufen die Stromversorgungsdrähte ausgehend von einem verbreiterten Mittelteil entlang des Randes der Leiterplatten zusammen. Die Leiterplatten sind dazu vorzugsweise rautenartig oder in der Art eines flachgedrückten Sechs- oder Achteckes ausgebildet, bei denen die langen Achsen entlang der Haupterstreckungsrichtung der Kette liegen.

Alternativ ist auch denkbar, dass als Leiterplatten metallische Leiterrahmen (Leadframes) dienen, auf denen die optischen

Emitter und ggf. die zugehörigen elektronischen Bauelemente angeordnet sind.

Ein besonderer Vorteil des erfindungsgemäßen Beleuchtungsmoduls besteht darin, dass es ohne Änderung der Produktion auf einfache Weise auf spezielle Kundenwünsche abgestimmt werden kann. Die Mäanderform des Stromversorgungskabelbündels zwischen den Leiterplatten erlaubt weitreichende Variationen des Abstandes zwischen den Leiterplatten und damit der Länge von ein und demselben Beleuchtungsmodul.

Ein Beleuchtungsmodul gemäß der Erfindung kann vorteilhafterweise auf einfache Weise mittels eines Reel-to-Reel-Verfahrens gefertigt werden, indem in "endloser" Form vorliegende Stromversorgungsleitungen in bestimmten Abständen abisoliert werden und an diesen Stellen die Leiterplatten an die im Übrigen durchgängigen Stromversorgungsleitungen angeschlossen und mit diesen verbunden werden.

Bei einer besonderes bevorzugten Ausführungsform verlaufen die Stromversorgungsleitungen ausschließlich auf der Vorderseite der Leiterplatten, auf der sich auch die optischen Emitter befinden. Die Leiterplatten können dann mit Vorteil eine flache Rückseite aufweisen, wodurch beispielsweise eine technisch einfache direkte Befestigung mittels einer Schraube durch ein dafür vorgesehenes Loch oder mittels einem doppelseitigem Klebeband möglich ist.

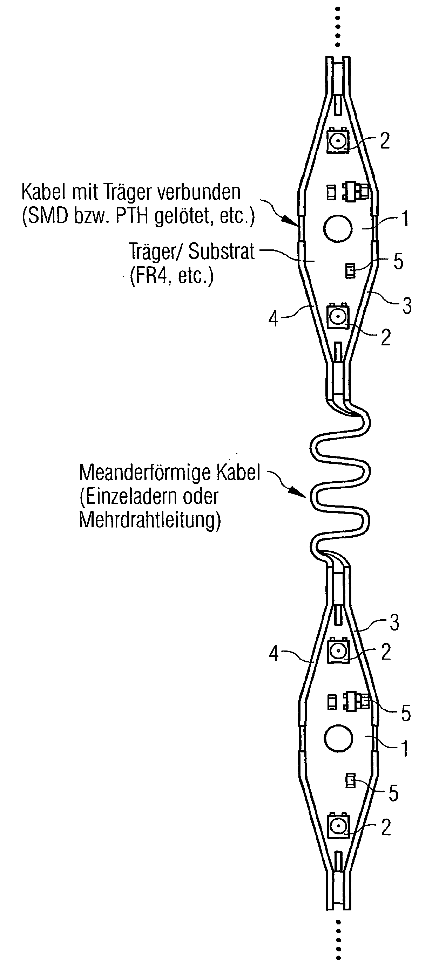

Weitere Vorteile, Weiterbildungen und vorteilhafte Ausführungsformen ergeben sich aus dem im Folgenden in Verbindung mit der Figur erläuterten Ausführungsbeispiel.

Die Figur zeigt eine schematische Darstellung einer Draufsicht auf das Ausführungsbeispiel.

Die Figur ist grundsätzlich nicht als maßstabsgerecht anzusehen. Die einzelnen Bestandteile sind grundsätzlich auch nicht mit den tatsächlichen Größenverhältnissen zueinander dargestellt.

Das Ausführungsbeispiel weist eine Mehrzahl von Leiterplatten 1 auf, auf denen als optische Emitter jeweils zwei Leuchtdiodenbauelemente 2 angeordnet sind und die über zwei elektrische Stromversorgungsdrähte 3,4 zu einer Kette verschaltet sind. Die elektrischen Stromversorgungsdrähte 3,4 sind ohne Unterbrechung über alle Leiterplatten 1 der Kette geführt und verschalten die Leiterplatten 1 der Kette parallel zueinander.

Auf den Leiterplatten 1 sind neben den Leuchtdiodenbauelementen 2 jeweils weitere elektronische Komponenten 5 angeordnet, die mit den Leuchtdiodenbauelementen 2 elektrisch verschaltet sind.

Die elektrischen Stromversorgungsdrähte 3,4 sind zur Versteifung der Verbindung zwischen jeweils zwei Leiterplatten 1 zwischen diesen zu einem Bündel zusammengeführt und verkrimpt. Alternativ kann ein Flachbandkabel verwendet sein, dass im Bereich der Leiterplatten aufgetrennt ist.

Bei einer Ausführungsform, bei der Leuchtdiodenbauelemente von jeweils zwei zueinander benachbarten Leiterplatten miteinander verschaltet sind erfolgt dies mittels eines weiteren Verbindungsdrahtes zwischen den beiden Leiterplatten.

Zwischen jeweils zwei Leiterplatten 1 verlaufen die Stromversorgungsdrähte 3,4 mäanderartig.

Die Leiterplatten 1 haben die Form eines entlang der Erstreckungsrichtung der Kette gestreckten Achteckes und die Stromversorgungsdrähte 3,4 laufen ausgehend von dem verbreiterten Mittelteil entlang des Randes der Leiterplatten zusammen. Sie weisen insbesondere keine Rückseitenkontakte auf, wodurch bei einer Montage des Beleuchtungsmoduls keine besonderen Vorkehrungen getroffen werden müssen um beispielsweise einen Kurzschluss zu vermeiden.

Die Leiterplatten weisen z.B. eine flache Rückseite auf, wodurch beispielsweise eine direkte Befestigung mittels einer Schraube durch ein dafür vorgesehenes Loch oder mittels einem doppelseitigem Klebeband möglich ist.

Das Beleuchtungsmodul kann vorteilhafterweise auf einfache Weise mittels eines Reel-to-Reel-Verfahrens gefertigt werden, indem in "endloser" Form vorliegende Stromversorgungsleitungen in bestimmten Abständen abisoliert werden und an diesen Stellen die Leiterplatten 1 an die im Übrigen durchgängigen Stromversorgungsleitungen angeschlossen und mit diesen verbunden werden.

Das Beleuchtungsmodul kann optional Sekundäroptiken zur Strahlformung aufweisen, beispielsweise in Form von lösbar (beispielsweise mittels Steckverbindung oder Klemmverbindung) oder unlösbar (beispielsweise mittels Klebstoff) auf den Leiterplatten 1 befestigten Sammel- oder Streulinsen und/oder diffraktiven Optiken (in den Figuren nicht gezeigt). Damit kann die Leuchtdichte und/oder die Homogenität der Leuchtdichte des Beleuchtungsmoduls durch Änderung des Abstrahlcharakters der Leuchtdiodenbauelemente 2 angepasst werden.

Die Beschreibung der Erfindung anhand des Ausführungsbeispieles ist selbstverständlich nicht als Beschränkung der Erfindung auf dieses Ausführungsbeispiel zu verstehen. Die in der vorstehenden Beschreibung, in der Zeichnung sowie in den Ansprüchen offenbarten Merkmale der Erfindung können sowohl einzeln als auch in beliebiger Kombination für die Verwirklichung der Erfindung wesentlich sein.

## Patentansprüche

1. Verformbares Beleuchtungsmodul mit einer Mehrzahl von Leiterplatten (1), auf denen jeweils mindestens ein optischer Emitter (2) angeordnet ist und die über zwei elektrische Stromversorgungsdrähte (3, 4) zu einer Kette verschaltet sind,
**dadurch gekennzeichnet, dass**
die Leiterplatten (1) gedruckte Leiterplatten (PCB) oder Leiterplatten, die mittels MID-Technologie hergestellt sind, sind und
die elektrischen Stromversorgungsdrähte (3, 4) ohne Unterbrechung über alle Leiterplatten (1) der Kette laufen und die Leiterplatten (1) der Kette parallel zueinander verschalten.

2. Beleuchtungsmodul nach Anspruch 1, bei dem auf einer Leiterplatte (1) neben dem mindestens einen optischen Emitter (2) zusätzlich mindestens eine weitere elektronische Komponente (5) angeordnet und mit dem optischen Emitter (2) elektrisch verschaltet ist.

3. Beleuchtungsmodul nach Anspruch 1 oder 2, bei dem die elektrischen Stromversorgungsdrähte (3, 4) zur Versteifung der Verbindung zwischen jeweils zwei Leiterplatten (1) zwischen diesen zu einem Bündel verbunden sind.

4. Beleuchtungsmodul nach mindestens einem der Ansprüche 1 bis 3, bei dem die Leiterplatten (1) in eine Mehrzahl von Leiterplattenpaaren gruppiert sind und jeweils die optischen Emitter (2) eines Leiterplattenpaares mittels eines Verbindungsdrahtes zwischen den beiden Leiterplatten (1) verschaltet sind.

5. Beleuchtungsmodul nach mindestens einem der Ansprüche 1 bis 4, bei dem die optischen Emitter (2) Leuchtdiodenbauelemente sind.

6. Beleuchtungsmodul nach mindestens einem der Ansprüche 1 bis 5, bei dem die Stromversorgungsdrähte (3, 4) zwischen jeweils zwei Leiterplatten (1) mäanderartig verlaufen.

7. Beleuchtungsmodul nach mindestens einem der Ansprüche 1 bis 6, bei dem sich die Leiterplatten (1) in Richtung ihrer einander zugewandten Enden verjüngen und die Stromversorgungsdrähte (3, 4) ausgehend von einem verbreiterten Mittelteil entlang des Randes der Leiterplatten (1) zusammenlaufen.

8. Beleuchtungsmodul nach Anspruch 7, bei dem die Leiterplatten (1) rautenartig oder in der Art eines flachgedrückten Sechs- oder Achteckes ausgebildet sind, bei denen die langen Achsen entlang der Haupterstreckungsrichtung der Kette liegen.

9. Beleuchtungsmodul nach mindestens einem der Ansprüche 1 bis 8, bei dem jeweils sowohl der Biegeradius der Kette zwischen zwei Leiterplatten (1) als auch der Abstand zwischen den beiden Leiterplatten (1) variiert werden kann.

## Claims

1. Deformable illumination module with a plurality of circuit boards (1) that have at least one optical emitter (2) arranged thereon, respectively, and that are connected to form a chain via two electrical power supply wires (3, 4), **characterized in that** the circuit boards (1) are printed circuit boards (PCBs) or circuit boards manufactured by means of MID technology and the electrical power supply wires (3, 4) run without interruption across all circuit boards (1) of the chain thereby creating a parallel connection of the circuit boards (1) of the chain.

2. Illumination module according to Claim 1 wherein, aside from the at least one optical emitter (2), at least one further electronic component (5) is additionally arranged on a circuit board (1) and electrically connected to the optical emitter (2).

3. Illumination module according to Claim 1 or 2 wherein the electrical power supply wires (3, 4) are connected to form a bundle between two circuit boards, respectively, in order to reinforce the connection between two circuit boards (1).

4. Illumination module according to at least one of Claims 1 to 3 wherein the circuit boards (1) are grouped into a plurality of circuit board pairs and wherein the optical emitters (2), respectively, of a circuit board pair are connected by way of a connecting wire between the two circuit boards (1).

5. Illumination module according to at least one of Claims 1 to 4 wherein the optical emitters (2) are light-emitting diode component parts.

6. Illumination module according to at least one of Claims 1 to 5 wherein the power supply wires (3, 4) between two respective circuit boards (1) run in a meanderlike fashion.

7. Illumination module according to at least one of Claims 1 to 6 wherein the circuit boards (1) are tapered in the direction of their ends that are pointing toward each other and wherein the power supply wires (3, 4) run together, starting from a widened middle part, along the edge of the circuit boards (1).

8. Illumination module according to Claim 7 wherein the circuit boards (1) are configured in rhomboidal fashion or in the fashion of a flat-pressed hexagon or octagon having their long axes arranged along the main direction of extension of the chain.

9. Illumination module according to at least one of Claims 1 to 8 wherein both the bending radius of the chain between two circuit boards (1) and the distance between the two circuit boards (1) can in each case be varied.

## Revendications

1. Module d'éclairage déformable présentant plusieurs cartes de circuit (1) sur chacune desquelles au moins un émetteur optique (2) est disposé,
les cartes de circuit étant raccordées en une chaîne par deux fils (3, 4) d'alimentation en courant électrique,
**caractérisé en ce que**
les cartes de circuit (1) sont des cartes de circuit imprimé (PCB) ou des cartes de circuit réalisées par la technologie dite MID et
**en ce que** les fils (3, 4) d'alimentation en courant électrique s'étendent sans interruption sur toutes les cartes de circuit (1) de la chaîne et raccordent les cartes de circuit (1) de la chaîne les unes aux autres en parallèle.

2. Module d'éclairage selon la revendication 1, dans lequel, en plus du ou des émetteurs optiques (2), au moins un autre composant électronique (5) est disposé sur une carte de circuit (1) et est raccordé électriquement à l'émetteur optique (2).

3. Module d'éclairage selon les revendications 1 ou 2, dans lequel les fils (3, 4) d'alimentation en courant électrique sont reliés en un faisceau entre les cartes de circuit (1) des paires successives pour renforcer la liaison.

4. Module d'éclairage selon au moins l'une des revendications 1 à 3, dans lequel les cartes de circuit (1) sont regroupées en plusieurs paires de cartes de circuit, les émetteurs optiques (2) d'une paire de cartes de circuit étant raccordés au moyen d'un fil qui relie les deux cartes de circuit (1).

5. Module d'éclairage selon au moins l'une des revendications 1 à 4, dans lequel les émetteurs optiques (2) sont des composants à diode luminescente.

6. Module d'éclairage selon au moins l'une des revendications 1 à 5, dans lequel les fils (3, 4) d'alimentation en courant s'étendent en méandres entre les cartes de circuit (1) des paires successives.

7. Module d'éclairage selon au moins l'une des revendications 1 à 6, dans lequel les cartes de circuit (1) se rétrécissent dans la direction de leurs extrémités tournées l'une vers l'autre et en ce que les fils (3, 4) d'alimentation en courant se rapprochent mutuellement le long du bord des cartes de circuit (1) en partant d'une partie centrale élargie.

8. Module d'éclairage selon la revendication 7, dans lequel les cartes de circuit (1) sont configurées en forme de losange ou d'hexagone ou octogone aplati dont le grand axe est situé dans la direction d'extension principale de la chaîne.

9. Module d'éclairage selon au moins l'une des revendications 1 à 8, dans lequel tant le rayon de courbure de la chaîne entre deux cartes de circuit (1) que la distance entre les deux cartes de circuit (1) peuvent varier.
